# EUROPÄISCHE PATENTSCHRIFT

(11) **EP 3 799 539 B1**
(45) Veröffentlichungstag und Bekanntmachung des Hinweises auf die Patenterteilung: **16.03.2022**
(21) Anmeldenummer: 19200008.1
(22) Anmeldetag: 27.09.2019
(51) Int. Cl.: H05K 1/18

(54) **SCHALTUNGSTRÄGER, PACKAGE UND VERFAHREN ZU IHRER HERSTELLUNG**
CIRCUIT CARRIER, PACKAGE AND METHOD FOR ITS PRODUCTION
SUPPORT DE CIRCUIT, EMBALLAGE ET SON PROCÉDÉ DE FABRICATION

(43) Veröffentlichungstag der Anmeldung: 31.03.2021
(73) Patentinhaber: Siemens Aktiengesellschaft, 80333 München (DE)
(72) Erfinder: Pfefferlein, Stefan, 90562 Heroldsberg (DE)

(56) Entgegenhaltungen:
- EP-A1- 2 187 717
- US-A1- 2007 177 380
- US-A1- 2015 262 841

## Beschreibung

Die Erfindung betrifft einen Schaltungsträger zur Aufnahme eines Bare-Dies, wobei der Schaltungsträger zwei Lagen umfasst, wobei mindestens eine der beiden Lagen des Schaltungsträgers zumindest elektrisch leitfähig ist, vorzugsweise aus einem zumindest elektrisch leitfähigen Material besteht, und an einer ersten Seite des Schaltungsträgers angebracht ist, wobei die Lagen einen Zwischenraum definieren, der mit einem ersten Isoliermaterial vollständig ausgefüllt ist.

Darüber hinaus betrifft die Erfindung ein Herstellungsverfahren eines solchen Schaltungsträgers, wobei bei dem Verfahren eine Platte bereitgestellt wird, wobei die Platte zwei Lagen umfasst, wobei mindestens eine der beiden Lagen der Platte zumindest elektrisch leitfähig ist und an einer ersten Seite der Platte angeordnet ist, wobei die Lagen einen Zwischenraum definieren, der mit einem ersten Isoliermaterial vorzugsweise vollständig ausgefüllt ist.

Es versteht sich, dass es sich bei dem ersten Isoliermaterial der Platte um das erste Isoliermaterial in einem sogenannten Rohzustand handelt. Es kann beispielsweise ein Sheet-Material sein, das mehr oder weniger formstabil sein kann. Es kann beispielsweise in Form einer Paste vorliegen, zähflüssig, duktil sein, solange es an der zumindest elektrisch leitfähigen Lage an jener Stelle bleibt, an der es aufgetragen worden ist und nicht zerfließt.

Ferner betrifft die Erfindung ein Package mit einem vorgenannten Schaltungsträger und mindestens einem Bare-Die.

Außerdem betrifft die Erfindung ein Herstellungsverfahren eines solchen Packages, wobei das Verfahren von einer Platte der gleichen Art ausgeht, wie das vorgenannte Schaltungsträger-Herstellungsverfahren, also von einer Platte, die zwei Lagen umfasst, wobei mindestens eine der beiden Lagen der Platte zumindest elektrisch leitfähig ist und an einer ersten Seite der Platte angeordnet ist, wobei die Lagen einen Zwischenraum definieren, der mit einem ersten Isoliermaterial vorzugsweise vollständig ausgefüllt ist.

Obendrein betrifft die Erfindung einen Umrichter mit mindestens einem vorgenannten Schaltungsträger und/oder Package.

Die Schaltungsträger der oben genannten Art sind aus dem Stand der Technik bekannt - siehe z.B. Boettcher, L.; Manessis, D.; Ostmann, A.; Karaszkiewicz, S.; Reichl, H. Embedding of Chips for System in Package realization - Technology and Applications. 2008 3rd International Microsystems, Packaging, Assembly & Circuits Technology Conference (2008), Seiten 383 bis 386. ISSN 2150-5934.

Die Patentanmeldung US 2015/262841 A1 offenbart in Abbildung 11 einen Schaltungsträger, wobei dieser eine Aussparung aufweist, in der ein Halbleiterelement mit einer auf dem Schaltungsträger angebrachten elektrisch leitfähigen Lage elektrisch verbunden ist.

In dem vorgenannten wissenschaftlichen Artikel ist beispielsweise ein Schaltungsträger mit einem in den Schaltungsträger eingebetteten Halbleiter-Die geoffenbart. Der Halbleiter-Die - das elektronische Bauelement - weist mehr als einen Anschluss auf einer seiner Seiten auf. Dabei lassen sich die Anschlüsse auf dieser Bauelementseite meist nur über lasergebohrte Durchkontaktierungen (engl. Vias) kontaktieren.

Das Erzeugen von solchen Vias hat allerdings in vielerlei Hinsicht Nachteile. Erstens entstehen im Lötergebnis im Bereich der Vias Hohlräume, die in der Fachwelt als Voidansammlungen bekannt sind. Zweitens wird durch Vias die Stromtragfähigkeit begrenzt, da durch die Vias in der Regel - zumindest bei Transistoren - der Schaltstrom geführt wird. Drittens kann der Bare-Die auf der Seite mit den lasergebohrten Vias nur schlecht entwärmt werden, da die Vias eine gute thermische Kopplung an die Leiterbahnen begrenzen, somit kann eine ausreichende elektrische aber nur mangelnde thermische Ankoppelung an die Kupfer-Lage bzw. den Bauelementanschluss erreicht werden. Die Entwärmung kann in diesem Fall größtenteils nur über die Rückseite des Bauelements erfolgen.

Beidseitig entwärmbare Lösungen erfordern zwei Schaltungsträger beziehungsweise Leitstrukturen oder Leadframes, zwischen denen das Bauelement eingebracht und flächig kontaktiert werden kann. Solche Lösungen sind allerdings technisch aufwendig. Viertens wird durch Vias die Streuinduktivität beeinflusst. Fünftens ist Blind-Via-Laserbohren auf Chip-Pads ein sehr zeitintensiver und fehleranfälliger Prozessschritt.

Die Aufgabe der Erfindung besteht darin, einen Schaltungsträger zur Aufnahme eines elektronischen Bauelements zu schaffen, der mittels einfacher Leiterplattenprozesse hergestellt werden kann und nach der Aufnahme des Bare-Dies eine beidseitige flächige Kontaktierung ermöglicht.

Diese Aufgabe wird mit einem Schaltungsträger der oben genannten Art erfindungsgemäß dadurch gelöst, dass der Schaltungsträger mindestens einen derart deformierten Bereich aufweist, dass die zumindest elektrisch leitfähige Lage des Schaltungsträgers in dem deformierten Bereich eine Vertiefung aufweist, wobei die zumindest elektrisch leitfähige Lage des Schaltungsträgers zumindest in der Vertiefung eine Leiterbahnenstruktur aufweist, wobei die Vertiefung mit einem zweiten Isoliermaterial verfüllt ist, wobei eine zweite, der ersten Seite gegenüberliegende Seite des Schaltungsträgers in dem deformierten Bereich eine derart geformte Aussparung aufweist, dass in die Aussparung ein Bare-Die bestückt werden und dabei mit der zumindest elektrisch leitfähigen, an der ersten Seite des Schaltungsträgers angebrachten, mindestens elektrisch, vorzugsweise elektrisch und wärmetechnisch leitfähigen Lage, insbesondere mit der Leiterbahnenstruktur elektrisch in Kontakt gebracht werden kann. Dabei wird die Form der Aussparung beim Bestücken und Kontaktieren des Bare-Dies in den vorgenannten Schaltungsträger vorzugsweise nicht verändert.

Im Zusammenhang mit der vorliegenden Erfindung wird unter dem Begriff "Bare-Die" ein ungehäustes elektronisches Bauelement, z.B. ein Leistungshalbleiterschalter, ein Chip beziehungsweise ein Nacktchip verstanden.

Der Erfindung liegt die Erkenntnis zugrunde, dass bei einem Schaltungsträger auf Vias verzichtet werden kann, wenn dieser auf einer ersten Seite, an der eine mindestens elektrisch leitfähige Lage angebracht ist, eine Vertiefung vorzugsweise mit einer Leiterbahnenstruktur aufweist und auf einer zweiten Seite, die der ersten Seite gegenüber liegt, und zwar in jenem Bereich, der der Vertiefung gegenüber liegt, eine Aussparung zur Aufnahme eines elektronischen Bauelements und zum dessen In-Kontakt-Bringen mit der Leiterbahnenstruktur aufweist. Eine Aussparung zur Aufnahme eines elektronischen Bauelements bedeutet eine in Form und Größe dem elektronischen Bauelement passende Aussparung.

Des Weiteren liegt der Erfindung die Erkenntnis zugrunde, dass, um den vorgenannten Schaltungsträger herzustellen, der vorgenannte deformierte Bereich mit einer Vertiefung durch einen Umformprozess einer Platte (mit einem Halbzeug von dem ersten Isoliermaterial), beispielsweise während des Verpressens der Platte, ausgebildet und auf der der Vertiefung gegenüberliegenden Seite der Platte eine Aussparung zur Aufnahme eines elektronischen Bauelements erzeugt wird, wobei, wie noch weiter unten gründlicher erörtert wird, die zeitliche Abfolge des Erzeugens der Aussparung und des Umformprozesses geändert werden kann.

Obendrein liegt der Erfindung die Erkenntnis zugrunde, dass ausgehend von derselben Platte und einem zu bestückenden elektronischen Bauelement ein Package geschaffen werden kann, bei dem beispielsweise auf Via-Bohren verzichtet werden kann, wenn beispielsweise das elektronische Bauelement in die Aussparung vor dem Aushärten und Deformieren bestückt und vorzugsweise mit der mindestens elektrisch leitfähigen Platte kontaktiert wird.

Bei einer bevorzugten Ausführungsform kann die Leiterbahnenstruktur in dem Boden der Vertiefung ausgebildet sein. Dies ermöglicht eine Verwendung von einfachen und genauen Ätzmethoden. Denkbar ist auch Laser-Direkt-Strukturierung der Leiterbahnen.

Hinsichtlich der Materialeinsparungen und damit die Kontaktierungsstrukturen des Schaltungsträgers - nach außen hin - über das zweite Isoliermaterial erhaben bleiben können, kann es zweckdienlich sein, wenn ausschließlich die Vertiefung mit dem zweiten Isoliermaterial verfüllt ist, d.h. die Vertiefung ist maximal nur bis zu ihren Rändern gefüllt und es gibt kein zweites Isoliermaterial, das auf der ersten Seite außerhalb der Vertiefung vorkommt.

Hinsichtlich einer beidseitigen Entwärmung kann es zweckdienlich sein, wenn die zweite Lage aus einem zumindest wärmeleitenden Material ist.

Es ist denkbar, dass die zweite Lage aus demselben Material wie der Core des Schaltungsträgers also aus dem ersten Isoliermaterial ausgebildet ist.

Hinsichtlich einer Möglichkeit, den Schaltungsträger beidseitig zu kontaktieren, kann es von Vorteil sein, wenn die zweite Lage aus einem elektrisch leitfähigen Material ist.

Bei einer bevorzugten Ausführungsform kann es vorgesehen sein, dass beide Lagen aus demselben Material, vorzugsweise aus einem Metall, insbesondere aus Kupfer sind. Hierdurch kann ein zweilagiger oder doppelseitiger Schaltungsträger erzeugt werden. Solche Schaltungsträger können beispielsweise als Innenlagen eine Basis für mehrlagige Aufbauten (auch als Multilayer bezeichnet) bilden.

Die Herstellung des Schaltungsträgers kann vereinfacht werden, wenn eine zweite, der ersten Seite gegenüberliegende Seite des Schaltungsträgers in dem deformierten Bereich eine Erhöhung aufweist und die Aussparung in der Erhöhung ausgebildet ist.

Es kann zweckmäßig sein, wenn das erste Isoliermaterial ein thermisch verformbarer Kunststoff, vorzugsweise ein Prepregmaterial, beispielsweise ein glasfaserverstärktes Prepregmaterial, z.B. glasfaserverstärktes Laminat ist. Besonders geeignet für die Herstellung des Schaltungsträgers können jene thermisch verformbaren Materialien sein, die eine thermoplastische Vorstufe aufweisen.

Bei einer bevorzugten Ausführungsform kann es mit Vorteil vorgesehen sein, dass das zweite Isoliermaterial ein Harz oder ein Prepregmaterial ist. Das zweite Isoliermaterial kann beispielsweise ein Duroplast, vorzugsweise Phenolharz oder Epoxid sein. Das zweite Isoliermaterial kann beispielsweise ein chemisch härtendes Material mit einer flüssigen Vorstufe sein.

Hinsichtlich der Bestückung des Schaltungsträgers mit einem Bare-Die kann es zweckdienlich sein, wenn der Boden der Aussparung zumindest teilweise durch die an der ersten Seite des Schaltungsträgers angebrachten Lage aus dem zumindest elektrisch leitfähigen Material gebildet ist. Dabei können sich weitere Vorteile ergeben, wenn die Leiterbahnenstruktur in dem Boden der Vertiefung ausgebildet ist.

Darüber hinaus kann es zweckdienlich sein, wenn die Aussparung auf jener Seite, durch die der Bare-Die bestückt werden kann, offen ist und nach der Bestückung offenbleibt.

Es versteht sich, dass der Schaltungsträger mehrere, wie vorgenannt ausgebildete Aussparungen aufweisen kann. Dabei kann in jede Aussparung mindestens ein elektronisches Bauelement bestückt werden. In unterschiedliche Aussparungen können elektronische Bauelemente unterschiedlicher Art bestückt werden, wie z.B. laterale oder transversale Bauelemente.

Des Weiteren wird die Aufgabe mit einem (Schaltungsträger-) Herstellungsverfahren der oben genannten Art erfindungsgemäß dadurch gelöst, dass das Verfahren folgende Schritte umfasst:
- Aushärten der Platte, wobei beim Aushärten mindestens ein Bereich der Platte derart deformiert wird, dass die zumindest elektrisch leitfähige Lage in dem deformierten Bereich eine Vertiefung aufweist;
- Ausbilden einer Aussparung an einer zweiten, der ersten Seite gegenüberliegenden Seite der Platte;
- Strukturieren der zumindest elektrisch leitfähigen Lage, um eine Leiterbahnenstruktur vorzugsweise zumindest in der Vertiefung zu erhalten, wobei die Vertiefung und die Aussparung einander gegenüber liegen, wobei in die Aussparung ein Bare-Die bestückt werden und mit der zumindest elektrisch leitfähigen, an der ersten Seite des Schaltungsträgers angeordneten Lage aus dem zumindest elektrisch leitfähigen Material, insbesondere mit der Leiterbahnenstruktur elektrisch in Kontakt gebracht werden kann;
- Verfüllen der Vertiefung mit einem zweiten Isoliermaterial, vorzugsweise bis zu ihrem Rand.

An dieser Stelle sei angemerkt, dass die Reihenfolge der Schritte "Aushärten/Deformieren", also Erhalten eines stabilen Verbunds, "Ausbilden" und "Strukturieren" unterschiedlich sein kann. Unabhängig von der Reihenfolge kann von der Platte ausgegangen werden, bei der das erste Isoliermaterial noch nicht ausgehärtet ist (Halbzeug), d.h. die Platte in einem "Rohzustand" ist.

Jede der Reihenfolgen hat eigene Vorteile. Je nachdem welches Material als das erste Isoliermaterial verwendet wird, kann sich die eine oder die andere Reihenfolge der Schritte als vorteilhaft erweisen. Wenn beispielsweise ein glasfaserverstärktes Prepregmaterial als das erste Isoliermaterial verwendet wird, kann es zweckmäßig sein, zunächst die Aussparungen auszubilden und dann die Platte zu deformieren und auszuhärten, beispielsweise zu verpressen, weil das glasfaserverstärkte Prepregmaterial mechanisch stabil / formstabil genug ist, damit die ausgebildeten Aussparungen nach dem Aushärten und Deformieren - also in dem stabilen Verbund - erhalten bleiben. Bei anderen Materialien, z.B. bei den Prepregs, die kein stabilisierendes Glasfasergewebe enthalten, sondern nur aus Harzen mit anderen Füllstoffen bestehen, kann es zweckdienlich sein, zunächst die Platte zu deformieren und auszuhärten, damit ein stabiler Verbund entsteht und danach die entsprechenden Aussparungen auszubilden. Unabhängig davon, kann die zumindest elektrisch leitfähige Lage schon vor dem "Aushärten/Deformieren" und "Ausbilden" erfolgen.

Bei einem Massenherstellungsprozess kann es aus Kostengründen vorgesehen sein, dass das Strukturieren mittels Ätzens erfolgt. Denkbar ist allerdings auch, mittels eines Lasers zu strukturieren und insbesondere dabei die Laser-Direkt-Strukturierung zu verwenden.

Darüber hinaus kann vorgesehen sein, dass das Deformieren während des Verpressens erfolgt, d.h. die Platte wird derart verpresst, dass dabei der vorgenannte deformierte Bereich gebildet wird. Unter dem Verpressen wird das Verpressen unter Druck und Temperatur verstanden - ein Standardprozess in Leiterplattenherstellung.

Weitere Vorteile ergeben sich, wenn das Erzeugen der Aussparung durch Tieffräsen oder Ausstanzen erfolgt, wobei vorzugsweise bis zu der an der ersten Seite des Schaltungsträgers angeordneten, mindestens elektrisch leitfähigen Lage gefräst oder ausgestanzt wird.

Die Aufgabe wird auch mit einem Package gelöst, das den oben beschriebenen Schaltungsträger und mindestens ein elektronisches Bauelement, z.B. einen Bare-Die umfasst, wobei das elektronische Bauelement in der Aussparung bestückt ist und mit der zumindest elektrisch leitfähigen Lage elektrisch in Kontakt steht beziehungsweise elektrisch verbunden ist.

Es kann dabei mit Vorteil vorgesehen sein, dass die Aussparung (mit dem darin befindlichen Bare-Die) zumindest teilweise mit einem dritten Isoliermaterial gefüllt ist. Das dritte Isoliermaterial kann beispielsweise in etwa dieselben Eigenschafen wie das zweite Isoliermaterial besitzen - es kann z.B. chemisch härtend sein und/oder eine flüssige Vorstufe haben.

Weiterhin kann das dritte Isoliermaterial auch aus Bestandteilen des ersten Isoliermateriales bestehen. Dies kann vorkommen, wenn der Bare-Die zunächst in die Aussparung bestückt und kontaktiert wird und danach die bestückte Platte ausgehärtet und deformiert, z.B. verpresst wird, um einen stabilen Verbund zu erhalten. Dieser Vorgang wird im Zusammenhang mit dem Package-Herstellungsverfahren noch näher erläutert. Es kann zweckdienlich sein, wenn der Bare-Die mehrere elektrische Anschlüsse (Chip-Bond-Pads) aufweist, wobei die elektrischen Anschlüsse die Leiterbahnenstruktur kontaktieren.

Bei einer bevorzugten Ausführungsform kann vorgesehen sein, dass der Bare-Die als ein laterales Bauelement, beispielsweise als ein GaN-Bauelement oder ein vertikales beziehungsweise transversales Bauelement, beispielsweise als ein IGBT-Bauelement ausgebildet ist.

Um eine bessere thermische Entwärmung des Bare-Dies beziehungsweise des Packages zu ermöglichen, kann es zweckmäßig sein, wenn bei dem Package ein zusätzlicher Schaltungsträger vorgesehen ist und/oder ein Deckel als Heatspreader an dem Package angebracht ist. Der Schaltungsträger und/oder der Deckel ist dann an jener Seite des Bare-Dies angebracht ist, die der ersten Seite des Schaltungsträgers abgewandt ist - an der Rückseite.

Darüber hinaus kann vorgesehen sein, dass der zusätzliche Schaltungsträger eingerichtet ist, von dem Bare-Die Wärme abzuleiten und ihn elektrisch zu isolieren.

Wenn die zweite Lage auch elektrisch leitfähig ist, kann es zweckdienlich sein, wenn der zusätzliche Schaltungsträger mit der zweiten Lage, beispielsweise mittels eines Pads oder Bumps o.Ä., elektrisch verbunden ist. In diesem Fall kann der Bare-Die durch den zusätzlichen Schaltungsträger elektrisch kontaktiert werden.

Bei einer bevorzugten Ausführungsform kann vorgesehen sein, dass das Package als oberflächenmontiertes Bauelement ausgebildet ist.

Die Aufgabe wird auch mit einem Package-Herstellungsverfahren der oben genannten Art erfindungsgemäß dadurch gelöst, dass das Verfahren folgende Schritte umfasst:
- Aushärten der Platte, wobei beim Aushärten mindestens ein Bereich der Platte derart deformiert wird, dass die zumindest elektrisch leitfähige Lage in dem deformierten Bereich eine Vertiefung aufweist;
- Ausbilden einer Aussparung an einer zweiten, der ersten Seite gegenüberliegenden Seite der Platte;
- Bestücken mindestens eines elektronischen Bauelementes in die Aussparung;
- Strukturieren der zumindest elektrisch leitfähigen Lage, um eine Leiterbahnenstruktur zu erhalten,
wobei die Vertiefung und die Aussparung einander gegenüber liegen, wobei das mindestens eine elektronische Bauelement mit der zumindest elektrisch leitfähigen Lage elektrisch in Kontakt steht,
wobei vorzugsweise die zumindest elektrisch leitfähige Lage zumindest in der Vertiefung strukturiert wird und das mindestens eine elektronische Bauelement mit der Leiterbahnenstruktur elektrisch in Kontakt steht;
- Verfüllen der Vertiefung mit einem zweiten Isoliermaterial.

An dieser Stelle sei betont, dass es möglich ist, die Reihenfolge der Schritte in dem oben beschriebenen Package-Herstellungsverfahren sinngemäß zu ändern.

Beispielsweise kann bei einer bevorzugten Form des Verfahrens vorgesehen sein, dass zunächst die Aussparung in der bereitgestellten Platte ausgebildet, vorzugsweise ausgestanzt wird; danach der mindestens eine Bare-Die in die Aussparung bestückt wird, um eine bestückte Platte zu erhalten und danach die bestückte Platte ausgehärtet und dabei deformiert wird, vorzugsweise durch Verpressen, um den zumindest einen deformierten Bereich zu erhalten, in dem die mindestens elektrisch leitfähige Lage die Vertiefung an jener Stelle aufweist, die der Vertiefung gegenüber liegt. Dabei kann es zweckdienlich sein, wenn beim Deformieren der mindestens eine Bare-Die mit dem ersten Isoliermaterial isoliert wird - in diesem Fall besteht das vorgenannte dritte Isoliermaterial aus Bestandteilen des ersten Isoliermaterials. Der bestückte (und kontaktierter) Bare-Die wird bei der vorgenannten Schrittabfolge simultan bei Erzeugung der Kavität oder der Vertiefung, mit in Z-Richtung, also quer zu der Platte, "bewegt", wobei Bestandteile aus dem ersten Isoliermaterial dabei in die Zwischenräume zwischen Aussparung und der Bare-Die-Kontur fließen oder sich die Aussparungskontur unter Temperatur und Druck der Bare-Die-Umrisskontur anpasst.

Eine solche Schrittreihenfolge kann beispielsweise dann von Vorteil sein, wenn das Prepregmaterial, das als das erste Isoliermaterial benutzt wird, glasfaserverstärkt ist, z.B. ein Laminat aus noch nicht vernetztem Harz und Glasfasern ist. Eine Platte mit einem solchen Prepregmaterial ist im "Rohzustand" flexibel und kann - je nach Art - bereits auch in diesem Zustand bearbeitet werden, um beispielsweise die Aussparungen bzw. Fenster herauszuarbeiten. Wenn nun die Platte (unter Druck und Temperatur) verpresst wird (Standard-Leiterplatten-Prozess) beginnt das Harz zu fließen, haftet an der(den) Lage(n) und härtet aus. Dadurch entsteht ein stabiler Verbund. Während dieser Phase kann auch eine Formgebung (deformieren des mindestens einen Bereichs) erfolgen, um eine Kavität beziehungsweise Vertiefung zu erhalten. Dadurch dass das Prepregmaterial glasfaserverstärkt ist, bleiben die vorher ausgebildeten, vorzugsweise ausgestanzten Aussparungen nach dem Verpressen und Härten erhalten.

Bei einer weiteren bevorzugten Ausführungsform kann es von Vorteil sein, wenn zunächst die bereitgestellte Platte ausgehärtet und dabei deformiert wird, vorzugsweise durch Verpressen, um den mindestens einen deformierten Bereich zu erhalten, in dem die zumindest elektrisch leitfähige Lage die Vertiefung aufweist. Dabei wird eine Platte mit dem mindestens einen deformierten Bereich als stabiler Verbund erzeugt. Danach wird die Aussparung an der zweiten, der ersten Seite gegenüberliegenden Seite der Platte an jener Stelle ausgebildet, vorzugsweise tiefgefräst, die gegenüber der Vertiefung liegt. Anschließend wird der mindestens eine Bare-Die in die Aussparung bestückt, sodass der mindestens eine Bare-Die mit der zumindest elektrisch leitfähigen Lage elektrisch in Kontakt steht. Diese Reihenfolge kann sich vor allem dann als zweckmäßig erweisen, wenn das Prepregmaterial, das als das erste Isoliermaterial benutzt wird, kein stabilisierendes Glasfasergewebe enthält, sondern nur aus Harzen mit anderen Füllstoffen besteht. Dort ist dann aufgrund der fehlenden Formstabilität eine Bearbeitung im Rohzustand sehr schwierig. In diesem Fall ist das Einbringen der Aussparung vorzugsweise mittels rückseitigen Tiefenfräsens insbesondere bis Erreichen von der mindestens elektrisch leitfähigen Lage erst nach der Härtung - also nach Erhalt eines Verbunds - einfacher.

Bei einer bevorzugten Ausführungsform des Verfahrens kann vorgesehen sein, dass in einem zusätzlichen die Aussparung zumindest teilweise mit einem dritten Isoliermaterial gefüllt wird. Dies kann vor allem dann zweckmäßig sein, wenn die Aussparung erst nach dem Aushärten und Deformieren der Platte ausgebildet wird.

Die Erfindung samt weiteren Vorteilen ist im Folgenden anhand beispielhafter Ausführungsformen näher erläutert, die in der Zeichnung veranschaulicht sind. In dieser zeigt
- FIG 1: einen Schaltungsträger in perspektivischer Ansicht von schräg oben;
- FIG 2: eine Schnittdarstellung des Schaltungsträgers der FIG 1 in perspektivischer Ansicht von schräg oben;
- FIG 3: den Schaltungsträger der FIG 1 in perspektivischer Ansicht von schräg oben unten;
- FIG 4, 5: Schnittdarstellungen des Schaltungsträgers der FIG 3;
- FIG 6: eine Querschnittansicht einer weiteren Ausführungsform eines Schaltungsträgers;
- FIG 7: eine Platte mit einem ersten Isoliermaterial in einem Rohzustand;
- FIG 8: eine deformierte Platte mit dem ausgehärteten ersten Isoliermaterial;
- FIG 9, 10: Schnittdarstellungen der Platte der FIG 8;
- FIG 11: die Platte der FIG 8 mit einer Leiterbahnenstruktur;
- FIG 12: eine Schnittdarstellung der Platte der FIG 11;
- FIG 13: die Platte der FIG 11 mit einer mit einem zweiten Isoliermaterial verfüllten Vertiefung;
- FIG 14, 15: Schnittdarstellungen der Platte der FIG 13;
- FIG 16: die Platte der FIG 13 mit einer Aussparung auf der Rückseite - der Schaltungsträger;
- FIG 17, 18: Schnittdarstellungen des Schaltungsträgers der Figur 16;
- FIG 19, 20: Schnittdarstellungen eines Packages mit dem Schaltungsträger der Figuren 1 bis 5 bzw. der Figuren 16 bis 18 und mit einem isolierten BareDie;
- FIG 21: eine Querschnittansicht eines Packages mit dem Schaltungsträger der FIG 6 und mit einem BareDie;
- FIG 22, 23: Querschnittansichten eines Packages mit einem zusätzlichen Schaltungsträger;
- FIG 24: ein zu bestückender Schaltungsträger in perspektivischer Ansicht von schräg unten;
- FIG 25: eine Schnittdarstellungen des Schaltungsträgers der FIG 24;
- FIG 26: eine Schnittdarstellungen des Schaltungsträgers der FIG 24 mit einem zur Bestückung bereitstehenden Bare-Die;
- FIG 27: ein Package mit dem Schaltungsträger der FIG 24 bestückt mit einem nicht-isolierten Bare-Die;
- FIG 28, 29: Schnittdarstellungen des Packages der FIG 27;
- FIG 30: das Package der FIG 27 mit einem isolierten BareDie;
- FIG 31, 32: Schnittdarstellungen des Packages der FIG 30;
- FIG 33: ein Schaltungsträger-Modul mit mehreren Schaltungsträgern, und
- FIG 34: ein auf einer Leiterplatte bestücktes Package.

Im Folgenden bezeichnen - sofern nicht anders angegeben - gleiche Bezugszeichen gleiche Merkmale.

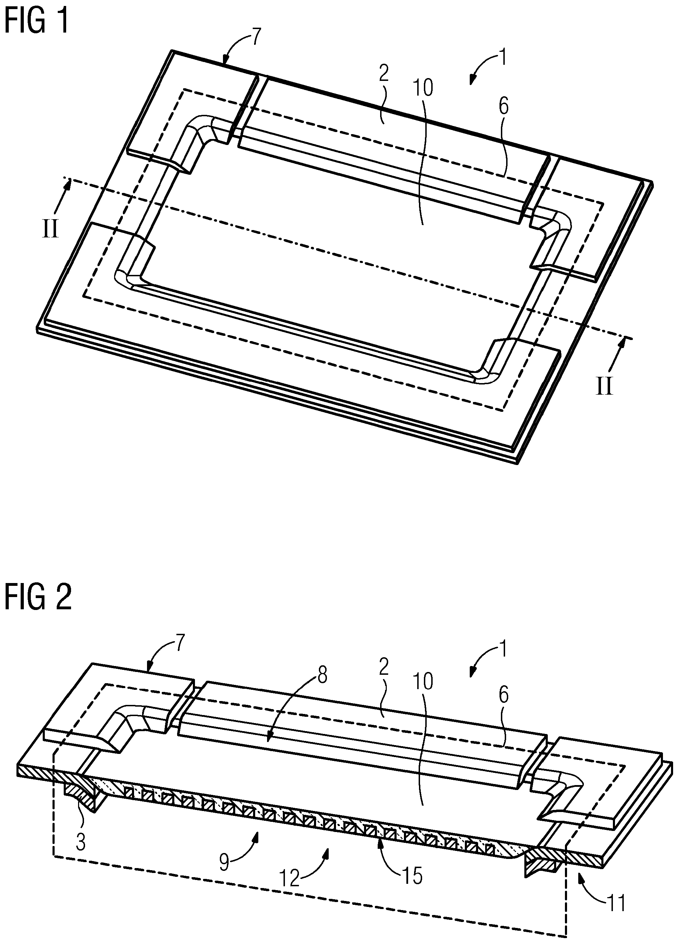

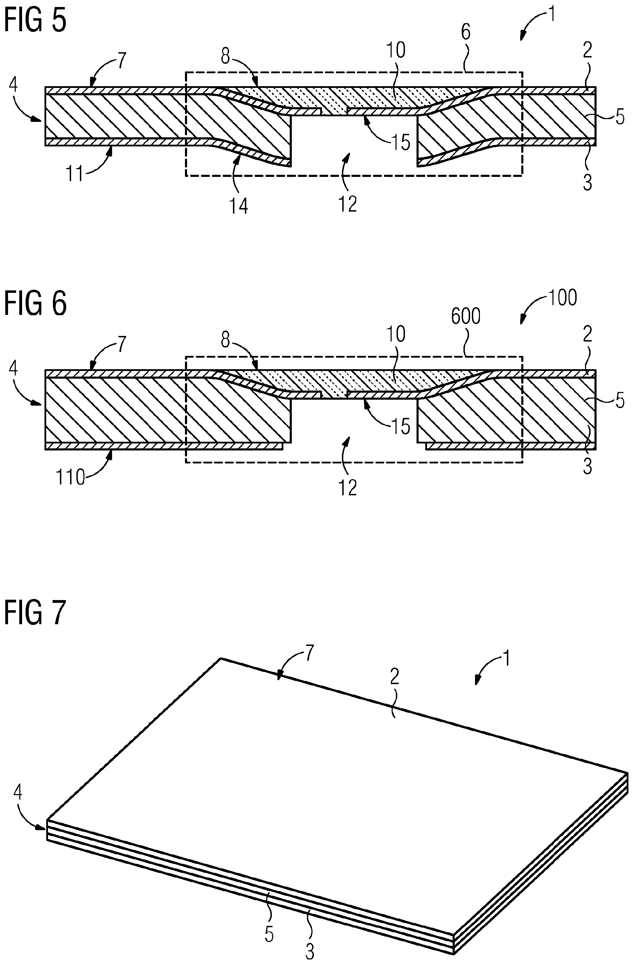

Zunächst wird auf die Figuren 1 bis 6 Bezug genommen. Die Figuren 1 bis 5 zeigen verschiedene Ansichten eines Schaltungsträgers 1 gemäß einer ersten Ausführungsform. FIG 6 ist eine Querschnittansicht eines Schaltungsträgers 100 gemäß einer zweiten Ausführungsform. Die nachstehende Beschreibung betrifft beide Ausführungsformen des Schaltungsträgers. Auf die Unterschiede zwischen den Ausführungsformen wird gesondert hingewiesen. Der Schaltungsträger 1, 100 weist zwei Lagen 2, 3 auf, wobei mindestens eine der beiden Lagen 2 des Schaltungsträgers 1, 100 aus einem zumindest elektrisch leitfähigen Material ist. Dieses Material ist vorzugsweise Kupfer. Verwendung von anderen elektrisch leitfähigen Materialien, z.B. Metallen, wie Aluminium, oder Legierungen ist ebenfalls denkbar. Die zumindest elektrisch leitfähige Lage 2 ist an einer ersten Seite 7 des Schaltungsträgers 1, 100 angebracht.

Zwischen den Lagen 2, 3 ist ein Zwischenraum 4 definiert. Dabei kann die zweite Lage 3 auch aus einem Dielektrikum bestehen, z.B. aus dem ersten Isoliermaterial ausgebildet sein.

Bevorzugt werden allerdings zumindest elektrisch leitfähige Lagen 2 und 3, beispielsweise Kupfer-Lagen verwendet.

Der Zwischenraum 4 ist mit einem ersten Isoliermaterial 5 ausgefüllt (siehe FIG 5 und 6), das den sogenannten Core bildet. Das erste Isoliermaterial 5 ist im Allgemeinen ein dielektrisches Material (ein Dielektrikum), das dem Schaltungsträger 1, 100 einerseits Robustheit und Härte verleiht und andererseits sich in seiner Vorstufe bzw. im Rohzustand (noch nicht vernetzt bzw. ausgehärtet) zumindest thermoplastisch verformen lässt. Bei dem ersten Isoliermaterial 5 kann es sich beispielsweise um einen thermoplastischen Kunststoff, wie z.B. Polyamid oder um ein Duroplast, wie z.B. Epoxidharz handeln. Ein besonders bevorzugtes Material ist dabei ein Prepregmaterial, beispielsweise ein glasfaserverstärktes Prepregmaterial, insbesondere glasfaserverstärktes Laminat. An dieser Stelle sei betont, dass viele andere Materialien als Core für den Schaltungsträger 1, 100 verwendet werden können, solange sie eine thermoplastische Vorstufe haben und nach Formgebung mittels Erwärmens, Bestrahlung oder durch chemische Reaktion (beispielsweise unter Zufuhr von Wärme) mindestens zweier Reaktanten ausgehärtet werden können.

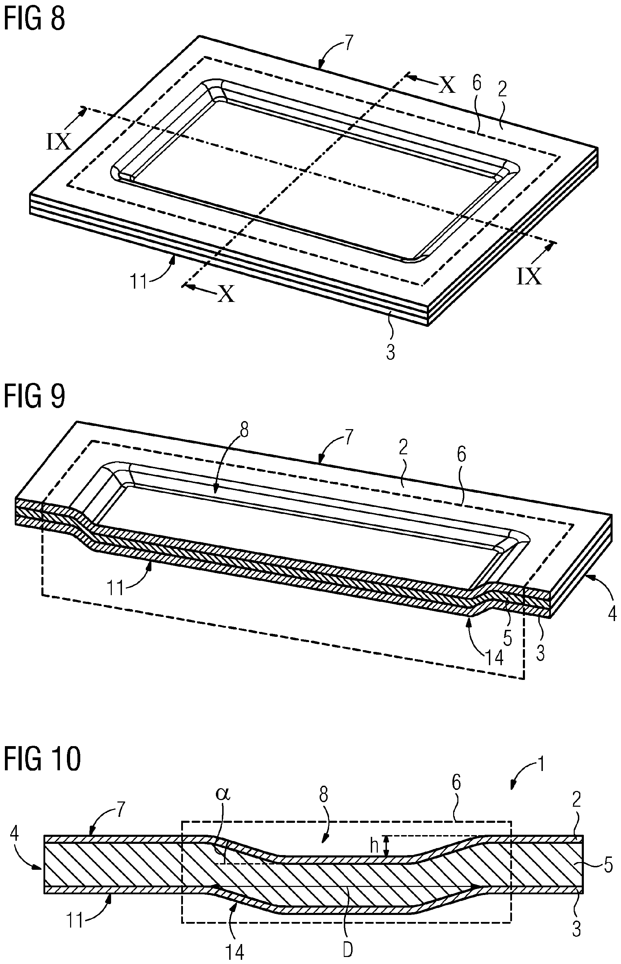

Außerdem weist der Schaltungsträger 1, 100 mindestens einen derart deformierten Bereich 6, 600 auf, dass die elektrisch leitfähige Lage 2 des Schaltungsträgers 1, 100 in dem deformierten Bereich 6, 600 eine Vertiefung 8 aufweist. Von oben gesehen (z.B. FIG 1 oder 2), kann sich die Vertiefung 8 über die gesamte obere Seite 7 des deformierten Bereichs 6, 600 erstrecken. Die Form der Vertiefung 8 kann in etwa der Form einer beispielsweise rechteckigen und insbesondere quadratischen Einbuchtung entsprechen. Sie kann beispielsweise, wie gezeigt, Form einer im Querschnitt trapezförmigen Wanne aufweisen (FIG 2). An dieser Stelle sei betont, dass der deformierte Bereich nicht nur die erste (obere) Seite 7, sondern auch den Core 5 und vorzugsweise eine zweite Seite 11 (die Rückseite) des Schaltungsträgers 1 umfasst. Der deformierte Bereich 6, 600 kann eine räumliche Ausdehnung D und eine Tiefe h aufweisen (siehe FIG 10). Die Ausdehnung D kann in etwa 0,5 bis 5 cm, insbesondere 1,5 cm betragen. Z.B. bei einem, von oben gesehen, quadratischen deformierten Bereich (nicht gezeigt) ist die Ausdehnung D in beiden horizontalen Richtungen gleich und kann z.B. 1,5cm x 1,5cm betragen. Bei bevorzugten Ausführungsformen kann die Tiefe h in etwa 200 bis 300 Mikrometer betragen. Die Flanken des deformierten Bereichs 6, 600 - d.h. die Übergänge zwischen einem nicht-deformierten Bereich der elektrisch leitfähigen Lage 2 und dem Boden der Vertiefung 8 - fallen zum Vertiefungsboden hin ab und können ein Gefälle von etwa 20 bis 30 Grad aufweisen. Es ist durchaus möglich, einen anderen Neigungswinkel α der Flanke zu dem nicht-deformierten Bereich der elektrisch leitfähigen Lage 2 zu verwirklichen. Bei einem zu steilen Winkel von z.B. 90 Grad bestünde allerdings die Gefahr eines Lagen- bzw. Folienrisses.

Dabei weist die zweite, der ersten Seite 7 gegenüberliegende Seite 11 (die Rückseite) des Schaltungsträgers 1 gemäß der ersten Ausführungsform eine der Vertiefung 8 entsprechende, vorzugsweise kongruente Erhöhung 14 auf. Die zweite Seite 110 des Schaltungsträgers 100 gemäß der zweiten Ausführungsform ist plan ausgebildet.

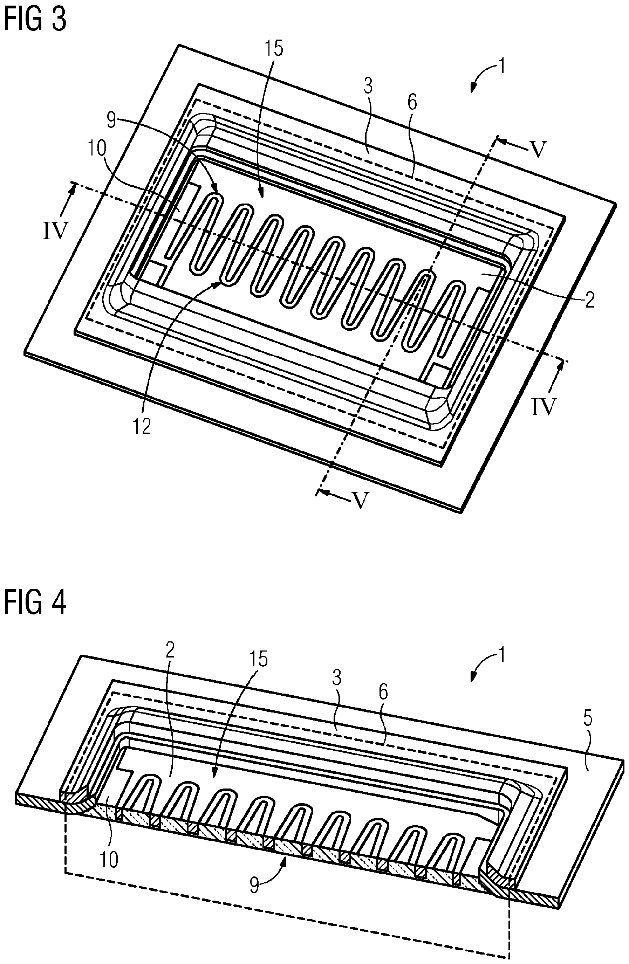

Die erste Seite 7 des Schaltungsträgers 1, 100 ist zumindest in der Vertiefung 8 strukturiert und weist eine Leiterbahnenstruktur 9 auf. Die Leiterbahnenstruktur 9 ist vorzugsweise in dem Boden der Vertiefung 8 ausgebildet. Die Leiterbahnenstruktur 9 kann beispielsweise mittels Ätztechnik/Subtraktivverfahren oder auch mithilfe eines Lasers, beispielsweise mittels eine Laser-Direkt-Strukturierung, erzeugt werden. Besonders in den Figuren 3 bis 5 ist es gut erkennbar, dass dabei eine Durchgangsnut, d.h. in dem Kontext - eine durch die zweite Lage 2 durchgehende Nut, in die zweite Lage 2 eingebracht werden kann. Je nach Anwendung kann die Leiterbahnenstruktur 9 verschiedene Formen haben. In dem gezeigten Beispiel ist die Durchgangsnut wellenförmig, beispielsweise sinusförmig. Die Leiterbahnenstruktur 9 korrespondiert vorzugsweise einer Gegenkontur (Kontur der Kontaktfläche) auf einem Halbleiter-Die, mit welchem der Schaltungsträger 1, 100 bestückt werden soll und die entsprechenden Kontaktierungsstellen aufweist. Die Geometrie der Leiterbahnenstruktur hängt generell von den geometrischen Kontaktflächen der Anschlüsse des zu bestückenden Halbleiter-Dies ab.

Die Vertiefung 8 ist mit einem zweiten Isoliermaterial 10 verfüllt. Vorzugsweise ist nur die Vertiefung 8 verfüllt, sodass kein zweites Isoliermaterial 10 über den Rändern der Vertiefung 8 vorhanden ist (siehe z.B. Figuren 1 bis 6). Das Aufbringen des zweiten Isoliermaterials 10 kann schon bei einer Raumtemperatur (ca. 25°C) möglich sein. Es ist auch denkbar, dass das zweite Isoliermaterial 10 aufgeheizt und über Dispensen, Jetten oder Rakeln aufgebracht wird. Dies hängt von der konkreten Materialwahl ab.

Bei dem zweiten Isoliermaterial 10 handelt es sich vorzugsweise ebenfalls um ein Dielektrikum. Besonders bevorzugt an dieser Stelle sind chemisch härtende Materialien, beispielsweise härtbare Polymere mit einer flüssigen Vorstufe, insbesondere Ein- oder Zwei-Komponenten-Epoxidharze. Es ist auch denkbar, dass physikalisch abbindende oder thermoplastische Stoffe als das zweite Isoliermaterial 10 verwendet werden. Ein Prepregmaterial (konfektioniertes Halbzeug) kann ebenfalls als zweites Isoliermaterial 10 fungieren.

In dem deformierten Bereich 6, 600 weist die zweite Seite 11, 110 (die Rückseite) des Schaltungsträgers 1, 100 eine derart geformte Aussparung 12 auf, dass in die Aussparung 12 ein Bare-Die 13 bestückt werden und dabei mit der zumindest elektrisch leitfähigen, an der ersten Seite 7 des Schaltungsträgers 1, 100 angebrachten Lage 2 elektrisch in Kontakt gebracht werden kann (siehe z.B. FIG 5). Dabei kann der Bare-Die 13 in der Aussparung 12 derart aufgenommen sein, dass zwischen dem Bare-Die 13 und Wänden der Aussparung ein Luftspalt bleibt.

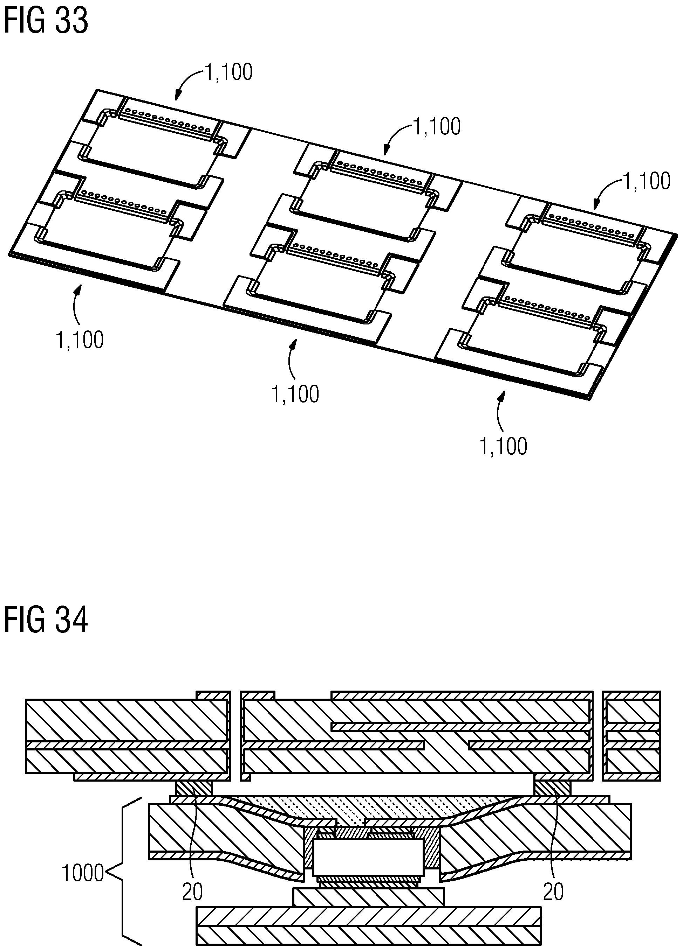

Es versteht sich, dass der Schaltungsträger 1, 100 mehrere, wie vorgenannt ausgebildete deformierte Bereiche 6, 600 und Aussparungen 12 aufweisen und somit mit mehreren Bare-Dies bestückt werden kann (siehe FIG 33). Dabei kann in jede Aussparung jeweils ein elektronisches Bauelement bestückt werden. In unterschiedliche Aussparungen können elektronische Bauelemente unterschiedlicher Art bestückt werden, wie laterale, z.B. GaN-, oder transversale, z.B. IGBT-, Bauelemente. In diesem Fall (FIG 33) kann es zweckdienlich sein, wenn die Schaltungsträger 1, 100 paarweise zu einer Halbbrücke verbunden sind.

Die zweite Lage 3 kann aus einem zumindest wärmeleitenden Material ausgebildet sein. Es ist denkbar, dass die zweite Lage aus demselben Material wie der Core des Schaltungsträgers 1, 100, also aus dem ersten Isoliermaterial 5 ausgebildet ist. Bevorzugt werden für die zweite Lage 3 jene Materialien verwendet, die sowohl Wärme als auch Strom leiten können, damit einerseits der Schaltungsträger 1, 100 beidseitig (elektrisch) kontaktierbar ist und andererseits die Wärme auch über die zweite Lage 3 effizient abgeleitet werden kann. Als solche Materialien bieten sich Metalle und insbesondere Kupfer an.

Figuren 1 bis 5 ist weiterhin zu entnehmen, dass die Aussparung 12 in der Erhöhung 14 ausgebildet sein kann. Im Allgemeinen ist die Aussparung 12 an jener Stelle der Rückseite 11, 110 des Schaltungsträgers 1, 100 ausgebildet, die der Vertiefung 8 gegenüberliegt.

In den Figuren 3 bis 6 ist besonders gut erkennbar, dass die Aussparung 12 so tief ausgebildet sein kann, dass ihr Boden 15 zumindest teilweise durch die an der ersten Seite 7 des Schaltungsträgers 1, 100 angebrachten Lage 2 aus dem zumindest elektrisch leitfähigen Material gebildet ist. Dies ermöglicht ein besonders günstiges Bonden von Bare-Dies 13 auf dem Schaltungsträger 1, 100.

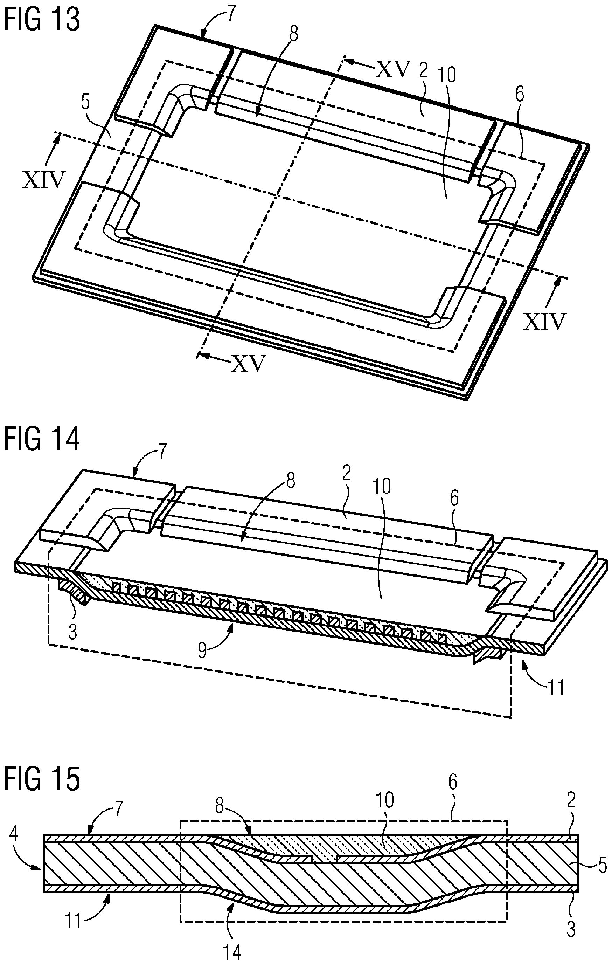

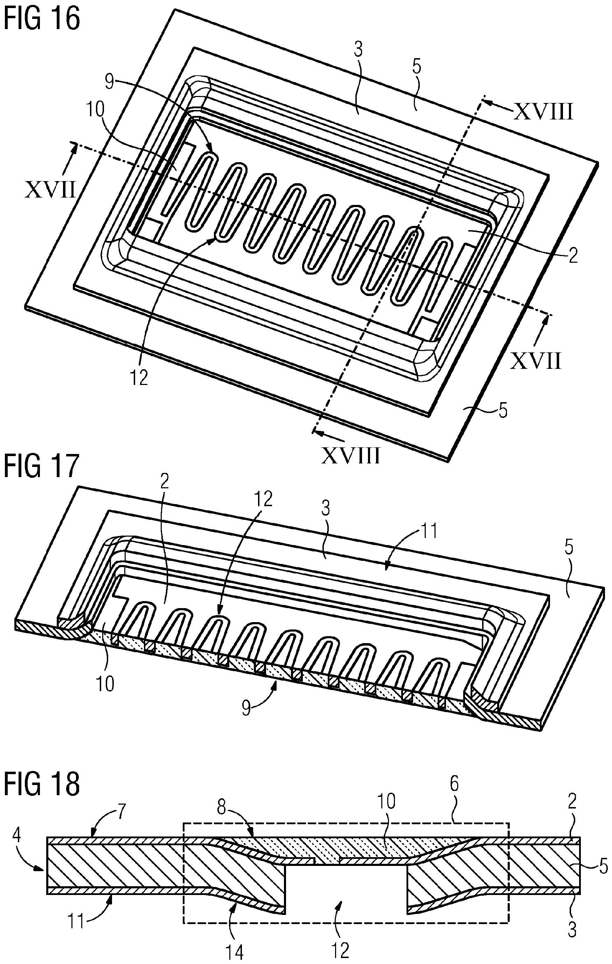

Figuren 7 bis 18 zeigen Zwischenprodukte, die nach jeweiligen Schritten eines Verfahrens entstehen, das beispielsweise zur Herstellung des oben beschriebenen Schaltungsträgers der Figuren 1 bis 5 verwendet werden kann.

Das Verfahren umfasst folgende Schritte. In einem Schritt wird eine, z.B. noch nicht verpresste, Platte bereitgestellt, wobei die Platte zwei Lagen 2, 3 umfasst und mindestens eine der beiden Lagen 2, 3 der Platte aus dem vorgenannten zumindest elektrisch leitfähigen Material, wie z.B. Kupfer, ist. Diese elektrisch leitfähige Lage 2 ist an einer ersten Seite 7 der Platte angeordnet. Zwischen den Lagen 2, 3 ist der Zwischenraum 4 definiert, der mit dem ersten Isoliermaterial 5 vollständig ausgefüllt ist. Solche Platten werden oft als Basismaterial bezeichnet. Dabei ist das erste Isoliermaterial 5 in seiner Vorstufe - Material im Rohzustand. Beispielsweise kann das erste Isoliermaterial 5 auf die erste Lage 2 in Form einer Paste aufgetragen worden sein. Eine solche Platte ist in FIG 7 dargestellt, wobei anzumerken ist, dass die zweite Lage 3 prinzipiell aus dem ersten Isoliermaterial 5 bestehen kann. Die (zweite) Lage 3 kann auch aus einem elektrisch leitfähigen Material, z.B. aus Kupfer ausgebildet sein.

In einem anderen Schritt (Schritt A) wird die Platte ausgehärtet und dabei mindestens ein Bereich 6 der Platte derart deformiert, dass die zumindest elektrisch leitfähige Lage 2 in dem deformierten Bereich 6 eine Vertiefung 8 aufweist (Figuren 8 bis 10). Dies kann durch Verpressen erfolgen. Dabei kann der mindestens eine Bereich 6 des Schaltungsträgers 1 derart deformiert werden, dass die zweite Seite 11 des Schaltungsträgers 1 (die Rückseite) in dem deformierten Bereich 6 eine Erhöhung 14 aufweist. Beispielsweise können bereits während des Verpressens des Basismaterials aus zwei Lagen 2, 3 (z.B. aus Kupfer) und dem ersten Isoliermaterial 5 (z.B. Prepregmaterial) die gewünschten Bereiche der Platte deformiert werden.

In einem anderen Schritt (Schritt B) wird die Aussparung 12 an der zweiten, der ersten Seite 7 gegenüberliegenden Seite 11 (an der Rückseite) der Platte ausgebildet.

Die zeitliche Reihenfolge der Schritte A und B ist frei wählbar und hängt, wie bereits in der Beschreibungseinleitung erklärt, im Wesentlichen davon ab, welches Material als das erste Isoliermaterial verwendet wird. Beispielsweise kann sich die Reihenfolge B-A bei glasverstärkten Prepregs besser eignen als die Reihenfolge A-B. Die Reihenfolge A-B kann sich wiederum besser eignen, wenn das erste Isoliermaterial 5 im Rohzustand die Form einer viskosen Paste aufweist.

Unabhängig von der Reihenfolge der Schritte A und B werden die Vertiefung 8 und die Aussparung 12 in dem deformierten Bereich 6, 600 derart erzeugt, dass sie einander gegenüberlieben und mindestens ein elektronisches Bauelement, z.B. ein Bare-Die 13 in die Aussparung 12 bestückt werden und mit der zumindest elektrisch leitfähigen, an der ersten Seite 7 des Schaltungsträgers 1 angebrachten Lage 2 - also mit dem Boden der Vertiefung 8 - elektrisch in Kontakt gebracht werden kann.

Weist die zweite Seite 11 die vorgenannte Erhöhung 14 auf, so wird die Aussparung 12 in der Erhöhung 14 gebildet. Es kann dabei zweckdienlich sein, wenn die Aussparung 12 bis zu der an der ersten Seite 7 des Schaltungsträgers 1 angebrachten Lage 2 aus dem zumindest elektrisch leitfähigen Material tief ist, so dass beispielsweise Bond-Pads (elektrische Anschlüsse) 17 des Bare-Dies 13 direkt auf das elektrisch leitfähige Material der mindestens einen Lage 2 aufgelegt werden können.

Das Erzeugen der Aussparung 12 kann beispielsweise durch Tieffräsen, insbesondere bei der Abfolge A-B, oder durch Ausstanzen, insbesondere bei der Abfolge B-A erfolgen.

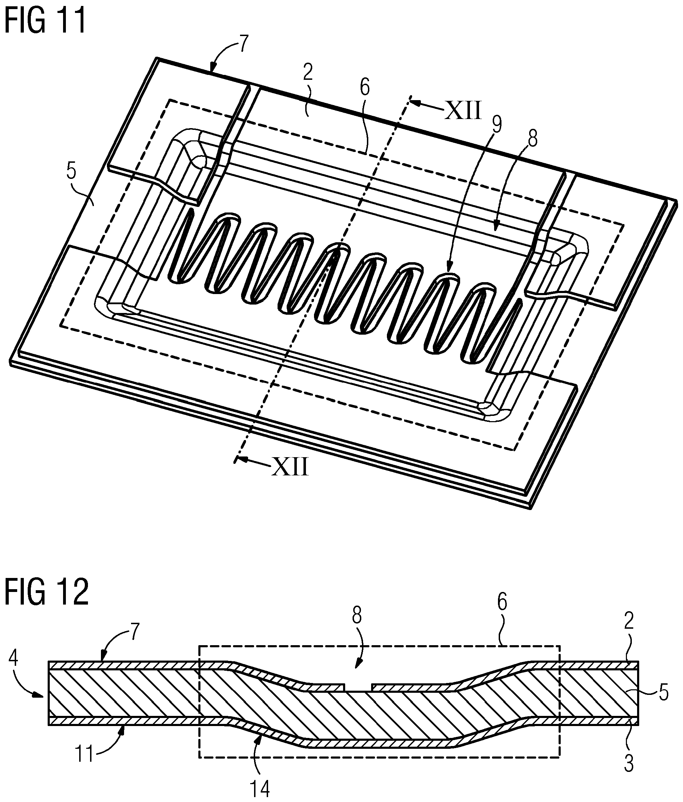

Um eine Leiterbahnenstruktur 9 zu erhalten, wird in einem Schritt des Verfahrens zumindest ein Teil der mindestens elektrisch leitfähigen Lage 2 strukturiert. Dieser Arbeitsschritt kann beispielsweise gleich nach Schritt A erfolgen, wodurch ein in Figuren 11 und 12 gezeigtes Zwischenprodukt erhalten werden kann. In diesem Fall wird die elektrisch leitfähige Lage 2 in dem bereits vorliegenden deformierten Bereich 6, und zwar vorzugsweise in einem Boden der Vertiefung 8 strukturiert. Dabei kann beispielsweise die Ätztechnik verwendet werden.

Denkbar ist aber auch, dass die Strukturierung der elektrisch leitfähigen Lage noch vor dem Schritt A und/oder B erfolgt. In einem solchen Fall wird die Vertiefung 8 beziehungsweise die Aussparung 12 in jenem Bereich der Platte ausgebildet, wo die Leiterbahnenstruktur 9 bereits vorliegt (die Aussparung 12 wird auf einer der Leiterbahnenstruktur 9 gegenüberliegenden Seite der Platte ausgebildet).

In einem anderen Schritt kann die Vertiefung 8 mit dem zweiten Isoliermaterial 10, vorzugsweise bis ihre Ränder verfüllt werden. Dadurch können Spannungsüberschläge zwischen einzelnen Leiterbahnen der Leiterbahnenstruktur 9 vermieden und Verlustströme reduziert werden.

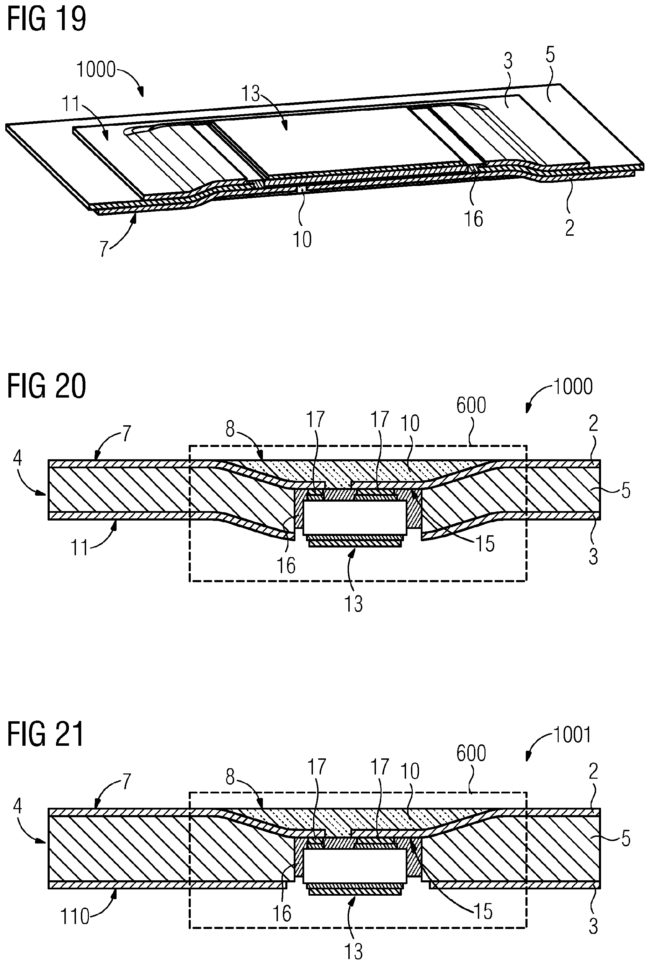

Figuren 19 bis 21 zeigen Packages, die beispielsweise mithilfe der oben beschriebenen Schaltungsträger 1, 100 erhalten werden können. Ein solches Package 1000, 1001 umfasst beispielsweise den Schaltungsträger 1 oder 100 und mindestens einen Bare-Die 13, der auf dem Schaltungsträger 1, 100 bestückt ist.

Der Bare-Die 13 ist also in der Aussparung 12 angeordnet und ist mit der zumindest elektrisch leitfähigen Lage 2 elektrisch verbunden. Dazu kann der Bare-Die 13 beispielsweise mehrere der vorgenannten elektrischen Anschlüsse 17 aufweisen, die mit Leiterbahnen der Leiterbahnenstruktur 9 in Kontakt stehen.

Falls notwendig, kann der Bare-Die 13 isoliert werden, indem ein optional vorhandener Luftspalt zwischen dem Bare-Die 13 und sowohl den Wänden als auch jenem Teil des Bodens der Aussparung 12, den der Bare-Die 13 nicht kontaktiert, mit zumindest teilweise mit einem dritten Isoliermaterial 16 gefüllt werden kann. Dadurch können beispielsweise die unterschiedlichen Anschlüsse 17 (die Bond-Pads) des Bare-Dies 13 voneinander elektrisch isoliert werden. Das dritte Isoliermaterial 16 - ein Dielektrikum - ist vorzugsweise aus der gleichen Gruppe der Stoffe gewählt, aus der das erste und das zweite Isoliermaterial gewählt sind. Es ist denkbar, dass alle drei Isoliermaterialien unterschiedlich oder gleich sind. Es ist auch denkbar, dass nur das zweite Isoliermaterial 10 dem dritten Isoliermaterial 16 gleich ist.

Wie bereits erwähnt, kann der Bare-Die 13 als ein laterales Bauelement, beispielsweise als ein GaN-Bauelement oder ein vertikales Bauelement, beispielsweise als ein IGBT-Bauelement ausgebildet sein.

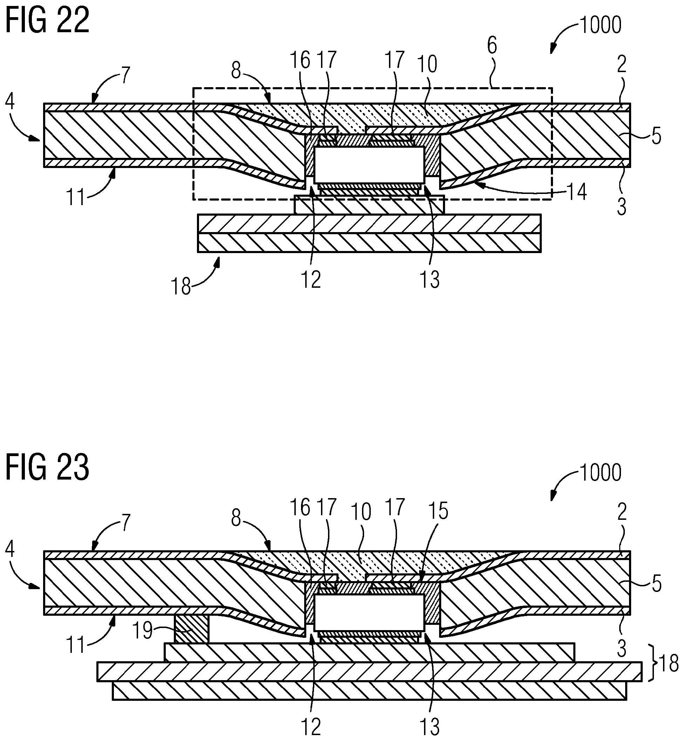

Beim Package 1000, 1001 kann darüber hinaus ein zusätzlicher Schaltungsträger 18 vorgesehen sein (siehe Figur 22 und 23). Dies kann beispielsweise ein keramischer Schaltungsträger, z.B. ein DCB-Schaltungsträger (engl. Direct Copper Bonded) sein. Der zusätzliche Schaltungsträger 18 kann an jener Seite des Bare-Dies 13 angebracht sein, die der ersten Seite 7 des Schaltungsträgers 1, 100 und - gemäß den in der Figuren 19 bis 21 gezeigten Beispielen - den Bond-Pads 17 gegenüberliegt. Die primäre Funktion des zusätzlichen Schaltungsträgers 18 kann z.B. die thermische Entwärmung des Packages 1000, 1001 sein. Darüber hinaus kann der zusätzliche Schaltungsträger 18 zu der elektrischen Isolation des Bare-Dies 13 verwendet werden. Dadurch kann ein einseitig kontaktierbares Package 1000 erhalten werden, wie dies der Figur 22 zu entnehmen ist.

Wenn die zweite Lage 3 elektrisch leitfähig ist, kann der zusätzliche Schaltungsträger 18 mit der zweiten Lage 3 (beispielsweise mittels eines Pads 19 oder Bumps o.Ä.) elektrisch verbunden sein. In diesem Fall leitet der zusätzliche Schaltungsträger 18 von dem Package 1000 die Wärme ab und sorgt gleichzeitig dafür, dass das Package 1000 beidseitig (elektrisch) kontaktierbar ist (siehe FIG 23).

Außerdem können die Lagen 2 und 3 elektrisch (über ein Via durch das Isolationsmaterial 5) verbunden werden. Dies ist insbesondere dann vorteilhaft, wenn das rückseitige Pad des Halbleiter-Dies auf ein Potenzial eines oberseitigen Pads gelegt werden soll. Vor allem bei lateralen Bauelementen (GaN) kann es zweckmäßig sein, wenn dieses Pad auf das Source-Potenzial gelegt wird, um kapazitive Umladungsverluste in dem Die beim Schalten zu reduzieren. Dies hängt aber von der Halbleiterarchitektur/-aufbau ab und beschreibt keine allgemeingültige Regel.

Das Package 1000, 1001 kann als oberflächenmontiertes Bauelement, beziehungsweise als ein SMD (englisch: Surface-mounted Device) ausgebildet sein. FIG 34 zeigt beispielhaft eine mit dem Package 1000 bestückte Leiterplatte. In diesem Fall kann das Package 1000 besonders leicht beispielsweise mittels weiterer vorzugsweise an der mindestens einen Lage 2 angeordneten Anschlüsse 20 auf eine Leiterplatte bestückt werden.

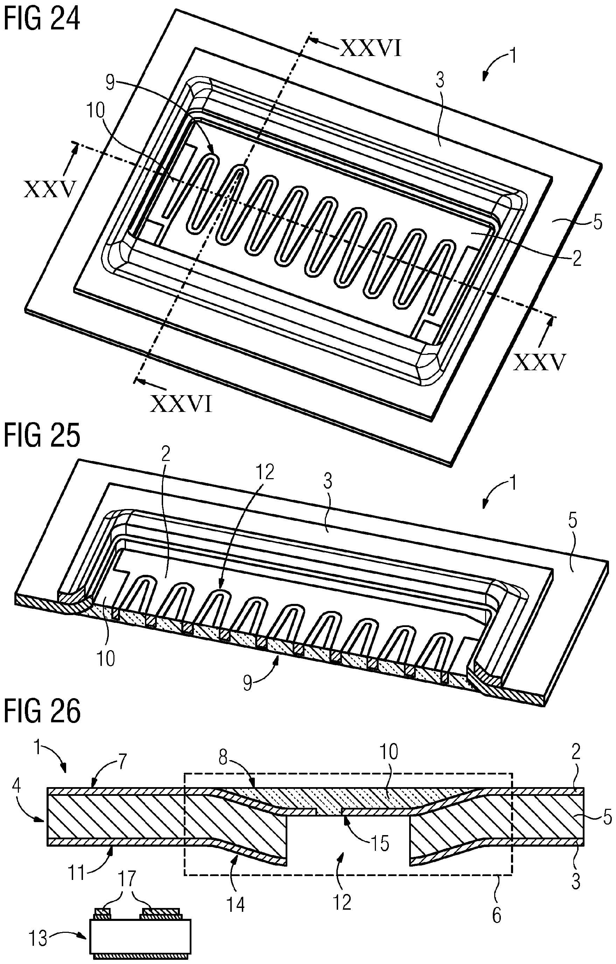

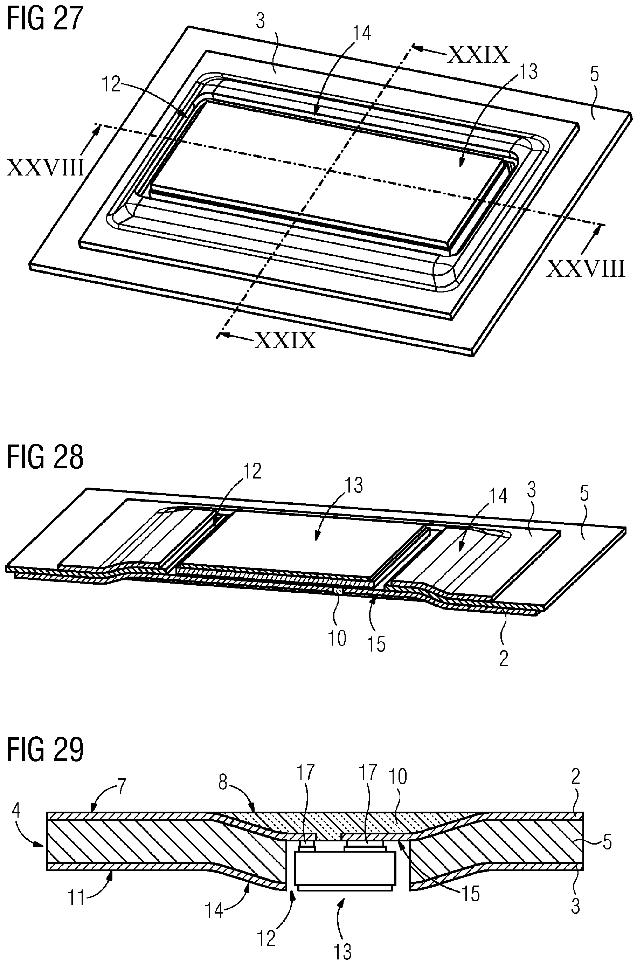

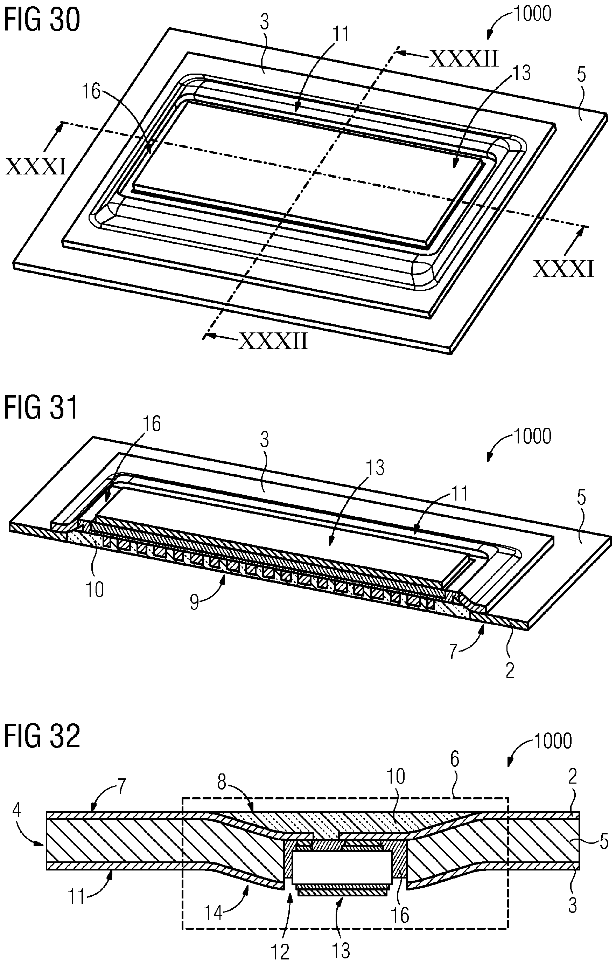

In den Figuren 24 bis 32 sind Zwischenprodukte einzelner Verfahrensschritte eines beispielhaften Verfahrens zur Herstellung des Packages 1000 (z.B. gemäß FIG 20) gezeigt. Es kann von einem Schaltungsträger 1, 100 und einem Bare-Die 13 ausgegangen werden (siehe Figuren 24 bis 26). Der Schaltungsträger 1, 100 kann dabei beispielsweise durch das vorgenannte Schaltungsträger-Herstellungsverfahren erhalten werden. Anschließend kann der Bare-Die 13 in die Aussparung 12 derart bestückt werden, dass der eine Bare-Die 13 mit der zumindest elektrisch leitfähigen Lage 2 elektrisch in Kontakt steht. Danach kann die Aussparung 12 zumindest teilweise mit dem dritten Isoliermaterial 16 gefüllt werden, sodass der vorgenannte Luftspalt (Figuren 27 bis 29) zwischen dem Bare-Die 13 und den die Aussparung 12 begrenzenden Flächen gefüllt wird und Anschlüsse 17 des Bare-Dies 13 voneinander isoliert werden können (Figuren 30 bis 32).

Nicht gezeigt in den Figuren ist die bereits erwähnte bevorzugte Form des Package-Herstellungsverfahrens, bei dem von der Platte in dem Rohzustand und einem elektronischen Bauelement, z.B. einem Bare-Die ausgegangen werden kann. Wie bereits beschrieben, kann bei dieser Ausführungsform zunächst die Aussparung in der bereitgestellten Platte ausgebildet, vorzugsweise ausgestanzt werden. Danach kann der Bare-Die in die in dem Halbzeug vom ersten Isoliermaterial ausgearbeitete Aussparung bestückt (und kontaktiert) werden, um eine bestückte Platte zu erhalten. Anschließend kann die bestückte Platte, vorzugsweise durch Verpressen, ausgehärtet und dabei deformiert werden, um den zumindest einen deformierten Bereich zu erhalten, in dem die mindestens elektrisch leitfähige Lage die Vertiefung an jener Stelle aufweist, die der Vertiefung gegenüber liegt. Dabei kann beim Aushärten und Deformieren, beispielsweise beim Verpressen unter Druck und Temperatur, das erhitzte erste Isoliermaterial in die Zwischenräume zwischen dem Bare-Die und der mindestens elektrisch leitfähigen Lage fließen und den Bare-Die zumindest teilweise einkapseln und isolieren. Das weitere Isolieren mit einem weiteren Isoliermaterial (z.B. mit einem dritten Isoliermaterial) kann somit entfallen. Auf dieser Weise kann z.B. das Package 1001 der Figur 21 erzeugt werden.

FIG 33 zeigt einen Schaltungsträger 1, 100 mit mehreren deformierten Bereichen 6, 600. Solche Schaltungsträger 1, 100 ermöglichen modul-/clusterartige Aufbauten. Die Schaltungsträger 1, 100 sind paarweise zu einer Halbbrücke verbunden sind.

Es ist ersichtlich, dass Abänderungen und/oder Hinzufügungen von Teilen an dem zuvor beschriebenen Schaltungsträger, dem Package oder ihren Herstellungsverfahren erfolgen können, ohne dass vom Gebiet und Umfang der vorliegenden durch die Ansprüche definierten Erfindung abgewichen wird. Ebenfalls ersichtlich ist, dass die Erfindung zwar in Bezug auf einige konkrete Beispiele beschrieben worden ist, ein Fachmann jedoch sicher in der Lage sein sollte, viele andere entsprechende Formen eines Schaltungsträgers, eines Packages oder ihrer Herstellungsverfahren zu erhalten, die die in den Ansprüchen dargelegten Eigenschaften aufweisen und damit alle in den dadurch festgelegten Schutzumfang fallen.

Zusammenfassend betrifft die Erfindung Schaltungsträger 1, 100 zur Aufnahme eines Bare-Dies, wobei der Schaltungsträger 1, 100 zwei Lagen 2, 3 umfasst, wobei mindestens eine der beiden Lagen 2 des Schaltungsträgers 1, 100 zumindest elektrisch leitfähig ist und an einer ersten Seite 7 des Schaltungsträgers 1, 100 angebracht ist, wobei die Lagen 2, 3 einen Zwischenraum 4 definieren, der mit einem ersten Isoliermaterial 5 vollständig ausgefüllt ist, wobei der Schaltungsträger 1, 100 mindestens einen derart deformierten Bereich 6, 600 aufweist, dass die zumindest elektrisch leitfähige Lage 2 des Schaltungsträgers 1, 100 in dem deformierten Bereich 6, 600 eine Vertiefung 8 aufweist, wobei die zumindest elektrisch leitfähige Lage 2 des Schaltungsträgers 1, 100 zumindest in der Vertiefung 8 eine Leiterbahnenstruktur 9 aufweist, wobei die Vertiefung 8 mit einem zweiten Isoliermaterial 10 verfüllt ist, wobei eine zweite, der ersten Seite 7 gegenüberliegende Seite 11, 110 des Schaltungsträgers 1, 100 in dem deformierten Bereich 6, 600 eine derart geformte Aussparung 12 aufweist, dass in die Aussparung 12 ein Bare-Die 13 bestückt werden und dabei mit der zumindest elektrisch leitfähigen, an der ersten Seite 7 des Schaltungsträgers 1, 100 angebrachten Lage 2 elektrisch in Kontakt gebracht werden kann.

Die Bezugszeichen in den Ansprüchen dienen lediglich zum besseren Verständnis der vorliegenden Erfindung und bedeuten auf keinen Fall eine Beschränkung der vorliegenden Erfindung.

## Patentansprüche

1. Schaltungsträger (1, 100) zur Aufnahme eines Bare-Dies, wobei der Schaltungsträger (1, 100) zwei Lagen (2, 3) umfasst, wobei mindestens eine der beiden Lagen (2) des Schaltungsträgers (1, 100) zumindest elektrisch leitfähig ist und an einer ersten Seite (7) des Schaltungsträgers (1, 100) angebracht ist, wobei die Lagen (2, 3) einen Zwischenraum (4) definieren, der mit einem ersten Isoliermaterial (5) ausgefüllt ist, wobei der Schaltungsträger (1, 100) mindestens einen derart deformierten Bereich (6, 600) aufweist, dass die zumindest elektrisch leitfähige Lage (2) des Schaltungsträgers (1, 100) in dem deformierten Bereich (6, 600) eine Vertiefung (8) aufweist, wobei die zumindest elektrisch leitfähige Lage (2) des Schaltungsträgers (1, 100) zumindest in der Vertiefung (8) eine Leiterbahnenstruktur (9) aufweist, wobei die Vertiefung (8) mit einem zweiten Isoliermaterial (10) verfüllt ist, wobei eine zweite, der ersten Seite (7) gegenüberliegende Seite (11, 110) des Schaltungsträgers (1, 100) in dem deformierten Bereich (6, 600) eine derart geformte Aussparung (12) aufweist, dass in die Aussparung (12) ein Bare-Die (13) bestückt werden und dabei mit der zumindest elektrisch leitfähigen, an der ersten Seite (7) des Schaltungsträgers (1, 100) angebrachten Lage (2) elektrisch in Kontakt gebracht werden kann.

2. Schaltungsträger nach Anspruch 1, wobei die zweite Lage (3) aus einem zumindest wärmeleitenden Material ist und/oder aus einem elektrisch leitfähigen Material ist.

3. Schaltungsträger nach Anspruch 1 oder 2, wobei das erste Isoliermaterial (5) ein thermisch verformbarer Kunststoff, vorzugsweise ein Prepregmaterial, beispielsweise ein glasfaserverstärktes Prepregmaterial ist.

4. Schaltungsträger nach einem der Ansprüche 1 bis 3, wobei das zweite Isoliermaterial (10) ein Harz oder ein Prepregmaterial ist.

5. Schaltungsträger nach einem der Ansprüche 1 bis 4, wobei der Boden (15) der Aussparung (12) zumindest teilweise durch die an der ersten Seite (7) des Schaltungsträgers (1, 100) angebrachten, zumindest elektrisch leitfähigen Lage (2) gebildet ist.

6. Verfahren zur Herstellung eines Schaltungsträgers (1, 100) nach einem der Ansprüche 1 bis 5 zur Aufnahme eines Bare-Dies (13), wobei das Verfahren folgende Schritte umfasst:
- Bereitstellen einer Platte, wobei die Platte zwei Lagen (2, 3) umfasst, wobei mindestens eine der beiden Lagen (2, 3) der Platte zumindest elektrisch leitfähig ist und an einer ersten Seite (7) der Platte angeordnet ist, wobei die Lagen (2, 3) einen Zwischenraum (4) definieren, der mit einem ersten Isoliermaterial (5) ausgefüllt ist;
- Aushärten der Platte, wobei beim Aushärten mindestens ein Bereich (6, 600) der Platte derart deformiert wird, dass die zumindest elektrisch leitfähige Lage (2) in dem deformierten Bereich (6, 600) eine Vertiefung (8) aufweist;
- Ausbilden einer Aussparung (12) an einer zweiten, der ersten Seite (7) gegenüberliegenden Seite (11, 110) der Platte;
- Strukturieren der zumindest elektrisch leitfähigen Lage (2), um eine Leiterbahnenstruktur (9) vorzugsweise zumindest in der Vertiefung (8) zu erhalten,
wobei die Vertiefung (8) und die Aussparung (12) einander gegenüber liegen, wobei in die Aussparung (12) ein Bare-Die (13) bestückt werden und mit der zumindest elektrisch leitfähigen, an der ersten Seite (7) des Schaltungsträgers (1, 100) angeordneten Lage (2), insbesondere mit der Leiterbahnenstruktur (9) elektrisch in Kontakt gebracht werden kann;
- Verfüllen der Vertiefung (8) mit einem zweiten Isoliermaterial (10).

7. Verfahren nach Anspruch 6, wobei das Aushärten und Deformieren durch Verpressen erfolgt.

8. Verfahren nach Anspruch 6 oder 7, wobei das Ausbilden der Aussparung (12) durch Tieffräsen oder Ausstanzen erfolgt, wobei vorzugsweise bis zu der zumindest elektrisch leitfähigen Lage (2) gefräst oder ausgestanzt wird.

9. Package umfassend einen Schaltungsträger nach einem der Ansprüche 1 bis 5 und mindestens einen Bare-Die (13), wobei der Bare-Die (13) in der Aussparung (12) bestückt ist und mit der zumindest elektrisch leitfähigen Lage (2) elektrisch in Kontakt steht.

10. Package nach Anspruch 9, wobei die Aussparung (12) zumindest teilweise mit einem dritten Isoliermaterial (16) gefüllt ist.

11. Package nach Anspruch 9 oder 10, wobei der Bare-Die (13) mehrere elektrische Anschlüsse (17) aufweist, wobei die elektrischen Anschlüsse (17) die Leiterbahnenstruktur (9) kontaktieren.

12. Package nach einem der Ansprüche 9 bis 11, wobei ein zusätzlicher Schaltungsträger (18) vorgesehen ist, der an jener Seite des Bare-Dies (13) angebracht ist, die der ersten Seite (7) des Schaltungsträgers (1, 100) abgewandt ist.

13. Umrichter umfassend einen Schaltungsträger nach einem der Ansprüche 1 bis 5 und/oder ein Package nach einem der Ansprüche 9 bis 12.

14. Verfahren zur Herstellung eines Packages, wobei das Verfahren folgende Schritte umfasst:
- Bereitstellen einer Platte, wobei die Platte zwei Lagen (2, 3) umfasst, wobei mindestens eine der beiden Lagen (2, 3) der Platte zumindest elektrisch leitfähig ist und an einer ersten Seite (7) der Platte angeordnet ist, wobei die Lagen (2, 3) einen Zwischenraum (4) definieren, der mit einem ersten Isoliermaterial (5) ausgefüllt ist;
- Aushärten der Platte, wobei beim Aushärten mindestens ein Bereich (6, 600) der Platte derart deformiert wird, dass die zumindest elektrisch leitfähige Lage (2) in dem deformierten Bereich (6, 600) eine Vertiefung (8) aufweist;
- Ausbilden einer Aussparung (12) an einer zweiten, der ersten Seite (7) gegenüberliegenden Seite (11, 110) der Platte;
- Bestücken mindestens eines Bare-Dies (13) in die Aussparung (12) ;
- Strukturieren der zumindest elektrisch leitfähigen Lage (2), um eine Leiterbahnenstruktur (9) zu erhalten,
wobei die Vertiefung (8) und die Aussparung (12) einander gegenüber liegen,
wobei der mindestens eine Bare-Die (13) mit der zumindest elektrisch leitfähigen Lage (2) elektrisch in Kontakt steht,
wobei die Leiterbahnenstruktur (9) vorzugsweise zumindest in der Vertiefung (8) angeordnet ist, wobei insbesondere der mindestens eine Bare-Die (13) mit der Leiterbahnenstruktur (9) elektrisch in Kontakt steht;
- Verfüllen der Vertiefung (8) mit einem zweiten Isoliermaterial (10).

15. Verfahren nach Anspruch 14, wobei
- zunächst die Aussparung (12) in der bereitgestellten Platte ausgebildet, vorzugsweise ausgestanzt wird, wobei danach der mindestens eine Bare-Die (13) in die Aussparung (12) bestückt wird, um eine bestückte Platte zu erhalten, wobei danach die bestückte Platte ausgehärtet bei dem Aushärten deformiert wird, wobei das Aushärten und Deformieren vorzugsweise durch Verpressen erfolgt, um den zumindest einen deformierten Bereich (6, 600) zu erhalten, in dem die zumindest elektrisch leitfähige Lage (2) die Vertiefung (8) an jener Stelle aufweist, die der Aussparung (12) gegenüberliegt, wobei vorzugsweise beim Deformieren der mindestens eine Bare-Die (13) mit dem ersten Isoliermaterial (5) isoliert wird;
oder wobei
- zunächst die bereitgestellte Platte ausgehärtet und bei dem Aushärten deformiert wird, wobei das Aushärten und Deformieren vorzugsweise durch Verpressen erfolgt, um den mindestens einen deformierten Bereich (6, 600) zu erhalten, in dem die zumindest elektrisch leitfähige Lage (2) die Vertiefung (8) aufweist, wobei danach die Aussparung (12) an der zweiten, der ersten Seite (7) gegenüberliegenden Seite (11, 110) der Platte an jener Stelle ausgebildet, vorzugsweise tiefgefräst wird, die der Vertiefung (8) gegenüber liegt, wobei danach der mindestens eine Bare-Die (13) in die Aussparung (12) bestückt wird, sodass der mindestens eine Bare-Die (13) mit der zumindest elektrisch leitfähigen Lage (2) elektrisch in Kontakt steht.

## Claims

1. Circuit carrier (1, 100) for receiving a bare die, wherein the circuit carrier (1, 100) comprises two layers (2, 3), wherein at least one of the two layers (2) of the circuit carrier (1, 100) is at least electrically conductive and is attached to a first side (7) of the circuit carrier (1, 100), wherein the layers (2, 3) define an intermediate space (4), which is filled with a first insulating material (5), wherein the circuit carrier (1, 100) has at least one region (6, 600) deformed in such a way that the at least electrically conductive layer (2) of the circuit carrier (1, 100) has an indentation (8) in the deformed region (6, 600), wherein the at least electrically conductive layer (2) of the circuit carrier (1, 100) has a trace structure (9) at least in the indentation (8), wherein the indentation (8) is filled in with a second insulating material (10), wherein a second side (11, 110) of the circuit carrier (1, 100) opposite the first side (7) has a cut-out (12) in the deformed region (6, 600) which is shaped in such a way that a bare die (13) can be populated in the cut-out (12) and, in doing so, can be brought into electrical contact with the at least electrically conductive layer (2) which is attached to the first side (7) of the circuit carrier (1, 100).

2. Circuit carrier according to claim 1, wherein the second layer (3) is made of an at least thermally conductive material and/or is made of an electrically conductive material.

3. Circuit carrier according to claim 1 or 2, wherein the first insulating material (5) is a thermally deformable plastic, preferably a prepreg material, for example a glassfibre reinforced prepreg material.

4. Circuit carrier according to claim 1 to 3, wherein the second insulating material (10) is a resin or a prepreg material.

5. Circuit carrier according to one of claims 1 to 4, wherein the base (15) of the cut-out (12) is at least partially formed by the at least electrically conductive layer (2) attached to the first side (7) of the circuit carrier (1, 100).

6. Method for manufacturing a circuit carrier (1, 100) according to one of claims 1 to 5 for receiving a bare die (13), wherein the method comprises the following steps:
- providing a board, wherein the board comprises two layers (2, 3), wherein at least one of the two layers (2, 3) of the board is at least electrically conductive and is arranged on a first side (7) of the board, wherein the layers (2, 3) define an intermediate space (4), which is filled with a first insulating material (5);
- curing the board, wherein during the curing at least one region (6, 600) of the board is deformed in such a way that the at least electrically conductive layer (2) has an indentation (8) in the deformed region (6, 600);
- forming a cut-out (12) on a second side (11, 110) of the board opposite the first side (7);
- structuring the at least electrically conductive layer (2) in order to obtain a trace structure (9), preferably at least in the indentation (8),
wherein the indentation (8) and the cut-out (12) lie opposite one another, wherein a bare die (13) can be populated in the cut-out (12) and brought into electrical contact with the at least electrically conductive layer (2) which is arranged on the first side (7) of the circuit carrier (1, 100), in particular with the trace structure (9);
- filling in the indentation (8) with a second insulating material (10).

7. Method according to claim 6, wherein the curing and deforming takes place by lamination.

8. Method according to claim 6 or 7, wherein the cut-out (12) is formed by deep milling or punching out, wherein the milling or punching out preferably takes place up to the at least electrically conductive layer (2).

9. Package comprising a circuit carrier according to one of claims 1 to 5 and at least one bare die (13), wherein the bare die (13) is populated in the cut-out (12) and is in electrical contact with the at least electrically conductive layer (2).

10. Package according to claim 9, wherein the cut-out (12) is at least partially filled with a third insulating material (16) .

11. Package according to claim 9 or 10, wherein the bare die (13) has a plurality of electrical terminals (17), wherein the electrical terminals (17) are in contact with the trace structure (9).

12. Package according to one of claims 9 to 11, wherein an additional circuit carrier (18) is provided, which is attached to the side of the bare die (13) which faces away from the first side (7) of the circuit carrier (1, 100).

13. Converter comprising a circuit carrier according to one of claims 1 to 5 and/or a package according to one of claims 9 to 12.

14. Method for manufacturing a package, wherein the method comprises the following steps:
- providing a board, wherein the board comprises two layers (2, 3), wherein at least one of the two layers (2, 3) of the board is at least electrically conductive and is arranged on a first side (7) of the board, wherein the layers (2, 3) define an intermediate space (4), which is filled with a first insulating material (5);
- curing the board, wherein during the curing at least one region (6, 600) of the board is deformed in such a way that the at least electrically conductive layer (2) has an indentation (8) in the deformed region (6, 600);
- forming a cut-out (12) on a second side (11, 110) of the board opposite the first side (7);
- populating at least one bare die (13) in the cut-out (12);
- structuring the at least electrically conductive layer (2) in order to obtain a trace structure (9),
wherein the indentation (8) and the cut-out (12) lie opposite one another,
wherein the at least one bare die (13) is in electrical contact with the at least electrically conductive layer (2),
wherein the trace structure (9) is preferably arranged at least in the indentation (8), wherein in particular the at least one bare die (13) is in electrical contact with the trace structure (9);
- filling in the indentation (8) with a second insulating material (10).

15. Method according to claim 14, wherein
- first the cut-out (12) is formed in the board provided, preferably is punched out, wherein the at least one bare die (13) is then populated in the cut-out (12), in order to obtain a populated board, wherein the populated board is then cured and deformed during the curing, wherein the curing and deforming preferably takes place by lamination, in order to obtain the at least one deformed region (6, 600), in which the at least electrically conductive layer (2) has the indentation (8) at the point which lies opposite the cut-out (12), wherein preferably, during the deforming, the at least one bare die (13) is insulated with the first insulating material (5);
or wherein
- first the provided plate is cured and deformed during the curing, wherein the curing and deforming preferably takes place by lamination, in order to obtain the at least one deformed region (6, 600), in which the at least electrically conductive layer (2) has the indentation (8), wherein the cut-out (12) is then formed, preferably deepmilled at the second side (11, 110) of the board opposite the first side (7) at the point which lies opposite the indentation (8), wherein the at least one bare die (13) is then populated in the cut-out (12), so that the at least one bare die (13) is in electrical contact with the at least electrically conductive layer (2).

## Revendications

1. Support (1, 100) de circuit de réception d'une bare-die, dans lequel le support (1, 100) de circuit comprend deux couches (2, 3), dans lequel au moins l'une des deux couches (2) du support (1, 100) de circuit est au moins conductrice de l'électricité et est mise sur une première face (7) du support (1, 100) de circuit, dans lequel les couches (2, 3) définissent un espace (4) intermédiaire, qui est rempli d'un premier matériau (5) isolant, dans lequel le support (1, 100) de circuit a au moins une partie (6, 600) déformée, de manière à ce que la couche (2) au moins conductrice de l'électricité du support (1, 100) de circuit ait, dans la partie (6, 600) déformée, un évidement (8), dans lequel la couche (2) au moins conductrice de l'électricité du support (1, 100) de circuit a au moins dans l'évidement (8) une structure (9) de piste conductrice, dans lequel l'évidement (8) est rempli d'une deuxième matériau (10) isolant, dans lequel une deuxième face (11, 110), opposée à la première face (7), du support (1, 100) de circuit a, dans la partie (6, 600) déformée, une cavité (12) conformée de manière à mettre dans la cavité (12) une bare-die (13) et ainsi à pouvoir la mettre en contact électriquement avec la couche (2) au moins conductrice de l'électricité mise sur la première face (7) du support (1, 100) de circuit.

2. Support de circuit suivant la revendication 1, dans lequel la deuxième couche (3) est un matériau au moins conducteur de la chaleur et/ou en un matériau au moins conducteur de l'électricité.

3. Support de circuit suivant la revendication 1 ou 2, dans lequel le premier matériau (5) isolant est une matière plastique déformable thermiquement, de préférence un matériau préimprégné, par un exemple un matériau préimprégné renforcé par de la fibre de verre.

4. Support de circuit suivant l'une des revendications 1 à 3, dans lequel le deuxième matériau (10) isolant est une résine ou un matériau préimprégné.

5. Support de circuit suivant l'une des revendications 1 à 4, dans lequel le fond (15) de la cavité (12) est formé au moins en partie par la couche (2) au moins conductrice de l'électricité mise sur la première face (7) du support (1, 100) de circuit.

6. Procédé de fabrication d'un support (1, 100) de circuit suivant l'une des revendications 1 à 5 pour la réception d'une bare-die (13), le procédé comprenant les stades suivants :
- on se procure une plaque, la plaque comprenant deux couches (2, 3), au moins l'une des deux couches (2, 3) de la plaque étant au moins conductrice de l'électricité et étant mise sur une première face (7) de la plaque, dans lequel les couches (2, 3) définissent un espace (4) intermédiaire, qui est rempli d'un premier matériau (5) isolant ;
- on durcit la plaque, dans lequel, lors du durcissement, on déforme au moins une partie (6, 600) de la plaque, de manière à ce que la couche (2) au moins conductrice de l'électricité ait, dans la partie (6, 600) déformée, un évidement (8) ;
- on constitue une cavité (12) sur une deuxième face (11, 110), opposée à la première face (7), de la plaque ;
- on structure la couche (2) au moins conductrice de l'électricité, pour obtenir une structure (9) de piste conductrice, de préférence au moins dans l'évidement (8),
dans lequel l'évidement (8) et la cavité (12) sont opposés l'un à l'autre, dans lequel, dans la cavité (12) une bare-die (13) est mise et peut être mise en contact électriquement avec la couche (2) au moins conductrice de l'électricité mise sur la première face (7) du support (1, 100) de circuit, notamment avec la structure (9) de piste conductrice ;
- on remplit l'évidement (8) d'un deuxième matériau (10) isolant.

7. Procédé suivant la revendication 6, dans lequel le durcissement et la déformation s'effectuent par compression.

8. Procédé suivant la revendication 6 ou 7, dans lequel la constitution de la cavité (12) a lieu par fraisage profond ou par estampage, dans lequel on fraise ou on estampe, de préférence jusqu'à la couche (2) au moins conductrice de l'électricité.

9. Boîtier comprenant un support de circuit suivant l'une des revendications 1 à 5 et au moins une bare-die (13), dans lequel la bare-die (13) est mise dans la cavité (12) et est en contact électrique avec la couche (2) au moins conductrice de l'électricité.

10. Boîtier suivant la revendication 9, dans lequel la cavité (12) est remplie au moins en partie d'un troisième matériau (16) isolant.

11. Boîtier suivant la revendication 9 ou 10, dans lequel la bare-die (13) a plusieurs bornes (17) électriques, dans lequel les bornes (17) électriques sont en contact avec la structure (9) de piste conductrice.

12. Boîtier suivant l'une des revendications 9 à 11, dans lequel il est prévu un support de circuit (18) supplémentaire, qui est mis sur la face de la bare-die (13), qui est loin de la première face (7) du support de circuit (1, 100).

13. Convertisseur comprenant un support de circuit suivant l'une des revendications 1 à 5 et/ou un boîtier suivant l'une des revendications 9 à 12.

14. Procédé de fabrication d'un boîtier, le procédé comprenant les stades suivants :
- on se procure une plaque, la plaque comprenant deux couches (2, 3) dans lequel au moins l'une des deux couches (2, 3) de la plaque est au moins conductrice d'électricité et est mise sur une première face (7) de la plaque, dans lequel les couches (2, 3) définissent un espace (4) intermédiaire, qui est rempli d'un premier matériau (5) isolant ;
- on durcit la plaque, dans lequel au durcissement on déforme au moins une partie (6, 600) de la plaque, de manière à ce que la couche (2) au moins conductrice de l'électricité ait, dans la partie (6, 600) déformée, un évidement (8) ;
- on constitue une cavité (12) sur une deuxième face (11, 110), opposée à la première face (7) de la plaque ;
- on met au moins une bare-die (13) dans la cavité (12) ;
- on structure la couche (2) conductrice au moins de l'électricité pour obtenir une structure (9) de piste conductrice,
dans lequel l'évidement (8) et la cavité (12) sont opposés l'un à l'autre,
dans lequel la au moins une bare-die (13) est en contact électriquement avec la couche (2) au moins conductrice de l'électricité,
dans lequel la structure (9) de piste conductrice est disposée de préférence au moins dans l'évidement (8), dans lequel notamment au moins une bare-die (13) est en contact électriquement avec la structure (9) de piste conductrice ;
- on remplit l'évidement (8) d'un deuxième matériau (10) isolant.

15. Procédé suivant la revendication 14, dans lequel :
- on constitue, de préférence par estampage, d'abord la cavité (12) dans la plaque que l'on s'est procuré, dans lequel ensuite on met la au moins une bare-die (13) dans la cavité (12) pour obtenir une plaque équipée, dans lequel ensuite on déforme la plaque équipée durcie lors du durcissement, dans lequel le durcissement et la déformation s'effectuent de préférence par compression, pour obtenir la au moins une partie (6, 600) déformée, dans laquelle la couche (2) au moins conductrice de l'électricité a l'évidement (8) à l'emplacement qui est opposé à la cavité (12), dans lequel de préférence lors de la déformation on isole la au moins une bare-die (13) par le premier matériau (5) isolant ;
ou dans lequel
- on durcit d'abord la plaque que l'on s'est procuré et on la déforme au durcissement, dans lequel le durcissement et la déformation s'effectuent de préférence par compression, pour obtenir la au moins une partie (6, 600) déformée, dans laquelle la couche (2) au moins conductrice de l'électricité a l'évidement (8), dans lequel ensuite on constitue de préférence par fraisage profond la cavité (12) sur la deuxième face (11, 110), opposée à la première face (7), de la plaque à l'endroit qui est opposé à l'évidement (8), dans lequel ensuite on met la au moins une bare-die (13) dans la cavité (12) de manière à ce que la au moins une bare-die (13) soit en contact électriquement avec la couche (2) au moins conductrice de l'électricité.
